(19)

Europäisches
Patentamt
European
Patent Office
Office européen
des brevets

(11) **EP 4 472 021 A1**

(12) **EUROPEAN PATENT APPLICATION**

(43) Date of publication:
**04.12.2024 Bulletin 2024/49**

(21) Application number: **24177913.1**

(22) Date of filing: **24.05.2024**

(51) International Patent Classification (IPC):
**H02J 7/00** (2006.01)   **G01R 31/392** (2019.01)
**H02J 3/32** (2006.01)

(52) Cooperative Patent Classification (CPC):
**H02J 7/0048; G01R 31/392; H02J 7/00712;**
H02J 3/32; H02J 7/005; H02J 2310/12

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **29.05.2023   IT 202300010779**

(71) Applicant: **Energy S.p.A.
38068 Rovereto (TN) (IT)**

(72) Inventors:
• **TINAZZI, Davide
38068 ROVERETO (Trento) (IT)**
• **TAFFURELLI, Andrea
38068 ROVERETO (Trento) (IT)**

(74) Representative: **Anselmi, Davide
Bugnion S.p.A.
Via Pancaldo, 68
37138 Verona (IT)**

(54) **ELECTRICAL ENERGY MANAGEMENT METHOD AND SOFTWARE FOR STORAGE SYSTEMS**

(57)    An electrical energy management method for storage systems connectable to the electrical grid (3), comprising a first verification cycle (100) for verifying the state of charge of a storage system (1), comprising the following operating steps:
- measuring the maximum state of charge in a predefined moment in time;
- verifying whether the measured maximum state of charge (SOCril) is greater or less than a predefined value of the maximum state of charge (SOC_MAX);
- if the measured maximum state of charge (SOCril) is less than said predefined value of the maximum state of charge (SOC_MAX), verifying for how long it has been less;
- if it has been less for a period of time exceeding a predefined time interval, modifying a usage value of the minimum state of charge (SOC_MIN) of the storage system (1) according to the following formula:
Usage value of the minimum state of charge (SOC_MIN) = Predefined value of the maximum state of charge (SOC_MAX) - measured value of the maximum state of charge (SOCril) + Default value of the minimum state of charge (SOCD).

Fig. 2

**Description**

**Technical field**

The present invention relates to an electrical energy management method and software for storage systems.
In particular, the present invention fits into the field of energy management system (EMS) software applications that control and monitor storage systems in the private, commercial, and industrial sectors.

**Prior art**

On the market at present there are countless EMS platforms for the energy management of storage systems, preferably applied to photovoltaic systems for electricity production 2. In particular, in this sector, there are known highly advanced platforms for the management of residential, commercial, and industrial storage systems, also ones capable of managing very large amounts of data traffic.
In particular, although the major manufacturers of storage systems provide control systems for managing batteries and measuring parameters in order to verify correct operation, there are no known control strategies sufficiently accurate for storage systems.
In detail, as it is known that battery performance declines as a result of prolonged use, it is necessary to efficiently monitor the correct operation of batteries, and in particular, the charging and discharging cycles thereof.

**Objects of the present invention**

In this situation, the object of the present invention is to provide an electrical energy management method and software for storage systems which remedies the aforementioned drawbacks.
In general, it is an object of the present invention to provide an electrical energy management method and software for storage systems which makes it possible to increase the life of the storage system/battery and the state of health (SOH) of the storage system itself.
It is in particular an object of the present invention to provide an electrical energy management method and software for storage systems that makes it possible to provide a more efficient control of the values of the storage system.
It is a further object of the present invention to provide an electrical energy management method and software for storage systems that makes it possible to optimise the operation of the storage system.
The specified objects are substantially achieved by an electrical energy management method and software for storage systems according to what is described in the appended claims.

**Brief description of the figures**

Additional features and advantages of the present invention will become more apparent from the detailed description of some preferred, but non-exclusive embodiments of an electrical energy management method and software for storage systems illustrated in the appended drawings, in which:

- figure 1 shows, in a schematic view, an example of application of the control method according to the present invention;
- figure 2 shows a control scheme according to the method of the present invention.

**Detailed description of one or more preferred embodiments according to the present invention**

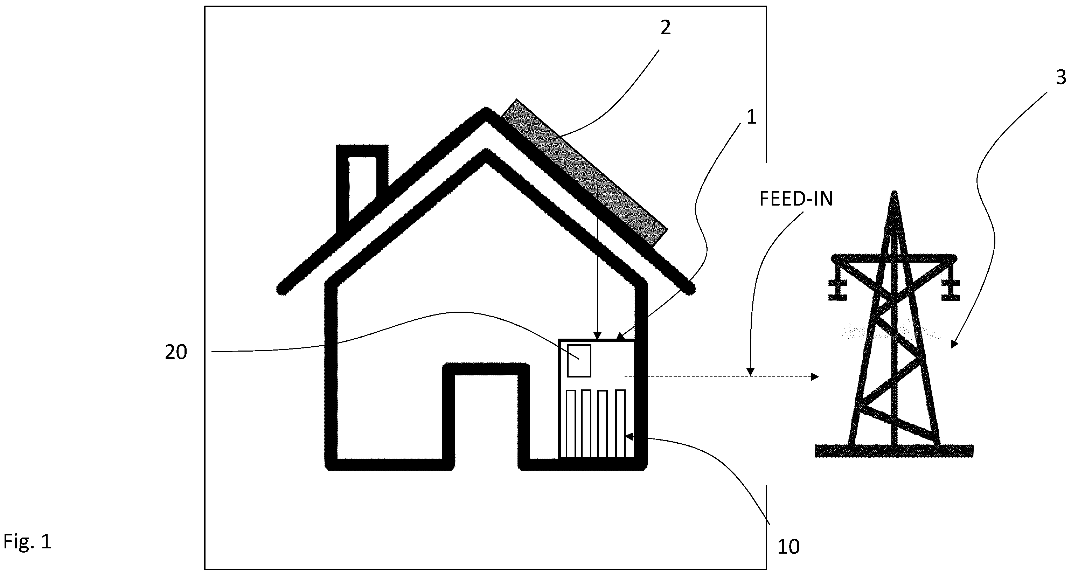

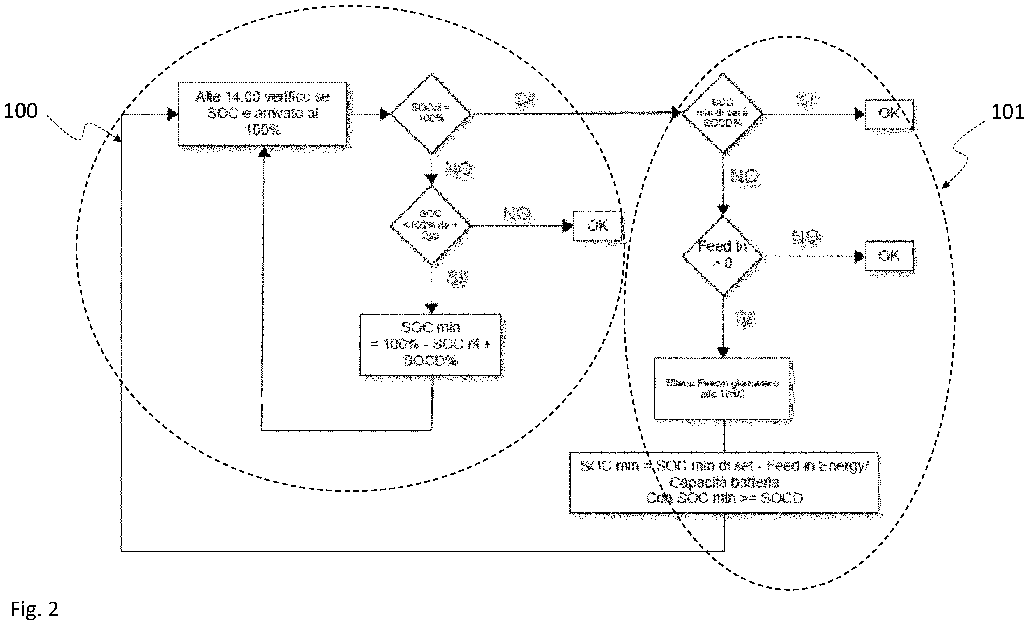

With reference to the aforesaid figures, the reference number 1 denotes in its entirety a storage system controlled by means of the method according to the present invention.
In particular, in figure 1 it is possible to see a schematically illustrated storage system 1 connected to a photovoltaic system 2, which supplies energy to recharge the batteries, and to the electrical grid 3 to feed electrical energy towards the grid.
However, it should be noted that the present invention is described and protected as such and thus not necessarily connected to a photovoltaic system 2. Therefore, the latter application of the invention must be considered only by way of non-exclusive example.
With reference to the following part of the description and, in particular, to the appended figure 2, it is necessary to explain the following meanings of the parameters that are taken into consideration:

H_CALC: Hour of the day in which the calculation is performed (parameter that can be set by the user);

N_DAYS: Days on which to verify the lack of a full charge (parameter that can be set by the user);
BATT_KWH: Capacity of the storage system 1 measured in kwh;
PERC_DEV: Percentage of deviation accepted;
SOC_MIN: Usage value of the minimum state of charge;
SOC_MAX: Predefined value of the maximum state of charge;
SOC_ril: Measured value of the maximum state of charge;
SOCD = Default value of the minimum state of charge, i.e. the value below which one must never go.

With particular reference to figure 2, the electrical energy management method comprises a first verification cycle 100 for verifying the state of charge of a storage system 1, wherein said first verification cycle 100 comprises the following operating steps:

- measuring the maximum state of charge SOCril at a predefined moment in time H_CALC;
- verifying whether the measured maximum state of charge SOCril is greater or less a predefined value of the maximum state of charge SOC_MAX;
- if the measured maximum state of charge SOCril is less than said predefined value of the maximum state of charge SOC_MAX, verifying for how long it has been less;
- if it has been greater for a period of time exceeding a predefined time interval, not modifying a usage value of the minimum state of charge SOC_MIN;
- if it has been less for a period of time exceeding a predefined time interval, modifying a usage value of the minimum state of charge SOC_MIN of the storage system 1 according to the following formula:

Usage value of the minimum state of charge SOC_MIN = Predefined value of the maximum state of charge SOC_MAX - measured value of the maximum state of charge SOCril + Default value of the minimum state of charge SOCD.

In figure 2 it is assumed that the measured maximum state of charge SOCril is 100%, assuming a storage system 1 at the maximum of its capacities. Furthermore, again in figure 2, it is assumed that the predefined time interval is two days (2 d).

It should be noted that the measurement of the maximum state of charge SOCril is performed every day in a same predefined time interval, preferably at the same hour.

Furthermore, the first verification cycle 100 is carried out every day in a same predefined time interval, preferably at the same hour.

For example, in figure 2 the first verification cycle 100 is carried out at 2:00 p.m. every day.

Preferably, the measurement of the maximum state of charge SOCril is performed at every predefined time interval (e.g. every minute) and the method envisages checking and possibly saving the values of the maximum state of charge SOCril and minimum state of charge SOC_MIN and an electrical energy FEED-IN value in a specific memory module.

At the set hour (H_CALC), the algorithm according to the present method checks the last N_DAYS of the saved array of daily values of the maximum state of charge. If all the values are less than the difference between the measured maximum state of charge SOCril and the percentage of accepted deviation PERC_DEV, the method calculates by how much to raise the usage value of the minimum state of charge SOC_MIN.

The usage value of the minimum state of charge SOC_MIN is raised by the difference between the maximum design state of charge SOC_MAX and the measured maximum state of charge SOCril reached on the last day considered.

If the measured value of the maximum state of charge SOCril is greater than or equal to said predefined value of the maximum state of charge SOC_MAX, the method envisages comparing the usage value of the minimum state of charge SOC_MIN of the storage system 1 with a default value of the minimum state of charge SOCD of the storage system 1.

If it emerges, from the comparison between the usage value of the minimum state of charge SOC_MIN of the storage system 1 and the default value of the minimum state of charge SOCD of the storage system 1, that the usage value of the minimum state of charge SOC_MIN is greater than the default value of the minimum state of charge SOCD, the following steps are performed (comprised in a second verification cycle 101):

- checking a value of electrical energy FEED-IN towards an external electrical grid 3;
- if that value of electrical energy FEED-IN is greater than zero, recalculating the usage value of the minimum state of charge SOC_MIN according to the following formula: state of charge SOCD - (electrical energy FEED-IN value / value of the battery storage Usage value of the minimum state of charge SOC_MIN = Default value of the minimum state of charge SOCD = (electrical energy FEED-IN value / value of the battery storage capacity BATT_KWH).

If, by contrast, the calculated usage value of the minimum state of charge SOC_MIN is greater than or equal to the default value of the minimum state of charge SOCD, emitting a signal of correct status of the storage system 1.

If the calculated usage value of the minimum state of charge SOC_MIN is less than the default value of the minimum state of charge SOCD, emitting a signal of poor status of the storage system 1.

In other words, if on the last day the design value of the maximum state of charge SOC_MAX was not reached correctly and the minimum usage value of the state of charge SOC_MIN was raised, the algorithm will recalculate it as a function of the ratio between the electrical energy FEED-IN value of the last 24 hours and the battery capacity BATT_KWH, subtracting the resulting value from the calculated usage value of the minimum state of charge SOC_MIN.

Advantageously, in this manner the batteries of the storage system are made to work towards the height of their capacity according to the availability of energy, thereby improving performance and the useful life.

A numerical example is given below:

SOC_MAX = 90 [%]
PERC_DEV = 10 [%]
N_DAYS = 7
SOCD = 20 [%]
SOC_MIN = 20 [%]
BATT_KWH = 100 [kWh]
H_CALC = 14:00

The method monitors the maximum and minimum values of the state of charge every day and puts them in an array. The value N_DAYS being set at seven, we will have arrays with seven values of the measured maximum state of charge SOCril with which to carry out checks at the preestablished hour (in this example at 2:00 p.m.).

Three different arrays of measurements of the measured maximum state of charge SOCril are used as an example, namely:

A1 = [85, 84, 83, 89, 81, 80, 82]
A2 = [85, 75, 76, 78, 70, 60, 20]
A3 = [72, 70, 65, 50, 55, 79, 72]

First Example (A1)

2:00 p.m. -> All the values are greater than SOC_MAX - PERC_DEV, i.e. 80%; therefore, the system is OK. SOC_MIN coincides with SOCD, so the values are correct.

Second Example (A2)

2:00 p.m. -> One measured value is greater than SOC_MAX - PERC_DEV, i.e. 80%; therefore, the system is OK.

SOC_MIN coincides with SOCD, so the values are correct.

Third Example (A3)

2:00 p.m. -> All the values of SOC_MAX are lower than 80%; therefore, it is necessary to recalculate SOC_MIN.

$$SOC\_MIN = SOCD + (SOC\_MAX - SOCril) = 20 + (90 - 79) = 31\ [\%]$$

As SOC_MIN has been modified, it is not necessary to perform other verifications.

The next day at 2:00 p.m., everything remains unchanged, but SOC_MIN is greater than SOCD and it is thus necessary to check the FEED-IN. If the FEED-IN is zero, it means that the system is OK.

If the feed-in increases to 200 kWh, it will be necessary to recalculate SOC_MIN as:

$$SOC\_MIN = SOC\_MIN - (FEED\_IN / BATT\_kWh) = 31 - (200 / 100) = 29$$

[%], which is a value greater than SOCD and thus accepted.

Furthermore, the present method envisages that said first verification cycle 100 for verifying the state of charge and/or said second verification cycle 101 for verifying the state of charge are carried out for every cell of the storage system 1. Therefore, N verification cycles will be carried out, depending on the number of cells of the storage system 1.

In addition, the method envisages a further step of checking the electrical voltage of each cell of the storage system 1, which comprises performing the following sub-steps:

detecting the cell having a higher value of electrical voltage than the other cells of the same storage system 1, detecting the cell having a lower value of electrical voltage than the other cells of the same storage system 1; calculating the difference between said higher value of electrical voltage and said lower value of electrical voltage.

In addition, the method envisages verifying:

whether the difference between said higher value of electrical voltage and said lower value of electrical voltage is less than a predefined range of values; if so, the system is OK;
whether the difference between said value of electrical voltage is greater and said lower value of electrical voltage value is greater than a predefined range of values;
if said difference is greater than said predefined range of values, carrying out a balancing step; said balancing step envisages maintaining the storage system (1) at a constant voltage for a certain period of time until reaching a predefined balancing state.

For example, if the cell with the highest voltage exceeds 3.36 V, and the difference between the cell with the highest voltage and the one with the lowest voltage is less than 50mV (predefined range of values), then the system is balanced.

If the difference between the cell with the highest voltage and the one with the lowest voltage is greater than 50mV, the method envisages carrying out a balancing step, which will maintain the system at a constant voltage for a certain period of time until it reaches a balanced state.

The "balanced state" or "balancing" corresponds to a state in which all the cells are maintained at a constant voltage or, at most, show differences between them which are lower than a predefined range of values.

If the cell with the highest voltage is below 3.36 V, and the difference between the cell with the highest voltage and the one with the lowest voltage is less than 30mV, then the system is balanced. If, by contrast, that difference is greater than 30mV, it goes into the balancing mode, which will maintain the system at a constant voltage for a certain period of time until it reaches a balanced state.

Advantageously the present invention enables the detection of an "unbalanced state" of voltage of the cells which corresponds to the amount by which the maximum voltage difference between the cells is greater than a predefined value.

The method envisages that, when an unbalanced state occurs, the use of the storage system/battery will be interrupted and a rebalancing step will be carried out which consists in a controlled recharging of the battery itself in order to rebalance the cells immediately and prevent them from deteriorating.

In other words, the rebalancing step is a recharging with an optimal current determined by a battery management system (BMS) module which provides for a realignment of the voltages of the various cells. In fact, it is not possible to recharge the cells individually, but as they are in series the current will flow through all of them equally, recharging and rebalancing them.

The subject matter of the present invention further relates to electrical energy management software for storage systems connectable to the electrical grid 3, which derives directly from what was illustrated above in relation to the method, which is entirely referenced here below.

The software envisages carrying out the above-described steps of the method by means of a processing unit.

In addition, the present invention relates to an electrical energy storage system 1 comprising:

a plurality of storage batteries 10 (defining said storage system 1 at least in part);
a processing unit 20 configured to execute the electrical energy management software described above.

Optionally, the storage batteries 10 can be connected to a photovoltaic system 2 in order to receive recharging energy from the latter.

Furthermore, preferably the storage batteries 10 can be connected to an external electrical grid 3 in order to deliver FEED-IN electrical energy towards the outside.

The present invention achieves the proposed objects.

First of all, thanks to the presence of the control method, it is possible to monitor the state of charge/discharge of the storage system in order to maintain values that enable an optimal equalisation of the cells and a state of charge (SOC) such as to maintain a good state of health (SOH) of the batteries.

Furthermore, the implementation of the method is not tied to system alarms or protection states, which can compromise the normal operation of the equipment with interruptions or de-rating of the service, but rather to strategies adapted to prevent potential failures and above all to improve the natural decay of lithium batteries.

It is thus a set of operations implemented at times and in ways that do not overlap with or undermine the normal operation of the system.

**Claims**

1. An electrical energy management method for storage systems connectable to the electrical grid (3), comprising a first verification cycle (100) for verifying the state of charge of a storage system (1), wherein said first verification cycle (100) comprises the following operating steps:

   - measuring the maximum state of charge (SOCril) at a predefined moment in time;
   - verifying whether the measured maximum state of charge (SOCril) is greater or less than a predefined value of the maximum state of charge (SOC_MAX);
   - if the measured maximum state of charge (SOCril) is less than said predefined value of the maximum state of charge (SOC_MAX), verifying for how long it has been less;
   - if it has been less for a period of time exceeding a predefined time interval, modifying a usage value of the minimum state of charge (SOC_MIN) of the storage system (1) according to the following formula:

   Usage value of the minimum state of charge (SOC_MIN) = Predefined value of the maximum state of charge (SOC_MAX) - measured value of the maximum state of charge (SOCril) + Default value of the minimum state of charge (SOCD);

   wherein said default value of the minimum state of charge (SOCD) is a default value of the minimum state of charge defined as per design;
   - if, by contrast, the measured value of the maximum state of charge (SOCril) is greater than or equal to said predefined value of the maximum state of charge (SOC_MAX), comparing the usage value of the minimum state of charge (SOC_MIN) of the storage system (1) with a default value of the minimum state of charge (SOCD) of the storage system (1);

   **characterised in that** if it emerges, from the comparison between the usage value of the minimum state of charge (SOC_MIN) of the storage system (1) and the default value of the minimum state of charge (SOCD) of the storage system (1), that the usage value of the minimum state of charge (SOC_MIN) is greater than the default value of the minimum state of charge (SOCD), a second verification cycle (101) is performed comprising the following steps:

   - checking a value of electrical energy feed-in (FEED-IN) towards an external electrical grid (3);
   - if that value of electrical energy feed-in (FEED-IN) is greater than zero, recalculating the usage value of the minimum state of charge (SOC_MIN) according to the following formula:

   Usage value of the minimum state of charge (SOC_MIN) = Default value of the minimum state of charge (SOCD) - (electrical energy feed-in value (FEED-IN) / value of the battery storage capacity (BATT_KWH));

   if the calculated usage value of the minimum state of charge (SOC_MIN) is greater than or equal to the default value of the minimum state of charge (SOCD), emitting a signal of correct status of the storage system (1);
   if the calculated usage value of the minimum state of charge (SOC_MIN) is less than the default value of the minimum state of charge (SOCD), emitting a signal of poor status of the storage system (1).

2. The method according to claim 1, wherein the measurement of the maximum state of charge (SOCril) is performed every day in a same predefined time interval, preferably at the same hour.

3. The method according to any one of the preceding claims, **characterised in that** said first verification cycle (100) is carried out every day in a same predefined time interval, preferably at the same hour.

4. The method according to any one of the preceding claims, **characterised in that** said first verification cycle (100) and/or said second verification cycle (101) is carried out for every cell of the storage system (1).

5. The method according to any one of the preceding claims, **characterised in that** it comprises a further step of checking the electrical voltage of each cell of the storage system (1) and of:
detecting the cell having a higher value of electrical voltage than the other cells of the same storage system (1),

   detecting the cell having a lower value of electrical voltage than the other cells of the same storage system (1);
   calculating the difference between said higher value of electrical voltage and said lower value of electrical voltage.

6. The method according to claim 5, **characterised in that** it comprises the following further steps:

   verifying whether the difference between said higher value of electrical voltage and said lower value of electrical voltage is greater than a predefined range of values;
   if said difference is greater than said predefined range of values, carrying out a balancing step; said balancing step envisages maintaining the storage system (1) at a constant voltage for a certain period of time until reaching a predefined balancing state.

7. Electrical energy management software for storage systems connectable to the electrical grid (3), comprising a processing unit (20) configured to carry out the steps of the method according to any one of the preceding claims.

8. An electrical energy storage system (1) comprising:

   a plurality of storage batteries (10);
   a processing unit (20) configured to execute the electrical energy management software for managing said storage batteries (10) according to claim 7.

Fig. 1

Fig. 2

Europäisches
Patentamt

European
Patent Office

Office européen
des brevets

## EUROPEAN SEARCH REPORT

Application Number

EP 24 17 7913

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 105 391 080 A (ELECTRIC POWER RES INST STATE GRID JIANGXI ELECTRIC POWER CO ET AL.) 9 March 2016 (2016-03-09) | 7,8 | INV. H02J7/00 G01R31/392 |
| A | * the whole document * | 1-6 | |
| X | CN 106 627 098 A (UNIV HENAN SCIENCE & TECH) 10 May 2017 (2017-05-10) | 7,8 | ADD. H02J3/32 |
| A | * the whole document * | 1-6 | |
| X | CN 105 656 067 A (CHINA ELECTRIC POWER RES INST; STATE GRID CORP CHINA ET AL.) 8 June 2016 (2016-06-08) | 7,8 | |
| A | * the whole document * | 1-6 | |
| X | CN 105 048 014 A (UNIV HARBIN SCIENCE & TECH) 11 November 2015 (2015-11-11) | 7,8 | |
| A | * the whole document * | 1-6 | |

TECHNICAL FIELDS
SEARCHED      (IPC)

H02J

The present search report has been drawn up for all claims

| Place of search | Date of completion of the search | Examiner |
|---|---|---|
| Munich | 27 September 2024 | Hartmann, Martin |

EPO FORM 1503 03.82 (P04C01)

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

## ANNEX TO THE EUROPEAN SEARCH REPORT
## ON EUROPEAN PATENT APPLICATION NO.

EP 24 17 7913

This annex lists the patent family members relating to the patent documents cited in the above-mentioned European search report.
The members are as contained in the European Patent Office EDP file on
The European Patent Office is in no way liable for these particulars which are merely given for the purpose of information.

27-09-2024

| Patent document cited in search report | | Publication date | Patent family member(s) | Publication date |
|---|---|---|---|---|
| CN 105391080 | A | 09-03-2016 | NONE | |
| CN 106627098 | A | 10-05-2017 | NONE | |
| CN 105656067 | A | 08-06-2016 | NONE | |
| CN 105048014 | A | 11-11-2015 | NONE | |

EPO FORM P0459

For more details about this annex : see Official Journal of the European Patent Office, No. 12/82